# EUROPÄISCHE PATENTSCHRIFT

(11) **EP 2 009 714 B1**
(45) Veröffentlichungstag und Bekanntmachung des Hinweises auf die Patenterteilung: **05.12.2018**
(21) Anmeldenummer: 08159270.1
(22) Anmeldetag: 27.06.2008
(51) Int. Cl.: B05D 1/00, C23C 14/12, C23C 14/22, C23C 14/24, C23C 14/32, C23C 14/54, H01L 51/00, H01L 51/52, H01L 51/56

(54) **Vorrichtung und Verfahren zum Abscheiden von dotierten Schichten mittels OVPD oder dergleichen**
Method and device for deposition of doped layers by means of OVPD or similar
Dispositif et procédé de déposition de couches dotées à l'aide d'OVPD ou similaire

(30) Priorität: 30.06.2007 DE 102007030499
(43) Veröffentlichungstag der Anmeldung: 31.12.2008
(73) Patentinhaber: Aixtron SE, 52134 Herzogenrath (DE)
(72) Erfinder: Kalisch, Holger, 41564, Kaarst (DE)
(74) Vertreter: Grundmann, Dirk

(56) Entgegenhaltungen:
- DE-A1- 10 212 923
- DE-A1- 10 307 125
- DE-A1- 10 338 406
- DE-A1- 19 822 333
- US-A- 5 156 815
- US-A- 5 554 220

## Beschreibung

Die Erfindung betrifft ein Verfahren zum Herstellen insbesondere dotierter Schichten für elektronische, lumineszierende oder photovoltaische Bauelemente, insbesondere OLEDs, wobei ein oder mehrere flüssige oder feste Ausgangsstoffe in einer Quelle verdampfen oder als Aerosol einem Trägergas beigemischt werden und in dieser Form in eine Depositionskammer transportiert werden, wo sie insbesondere in Folge eines Temperaturgradienten eine bevorzugt dotierte Matrix bildend auf einem Substrat kondensieren.

Die Erfindung betrifft darüber hinaus eine Vorrichtung zur Ausübung des Verfahrens, aufweisend die Quellen und die Quellen mit der Depositionskammer verbindende Gaszuleitungen sowie einen in der Depositionskammer angeordneten Suszeptor zur Aufnahme des Substrates.

Es ist bekannt, mittels organischer Ausgangsstoffe, die in Form von Salzen oder kleinen Molekülen vorliegen, elektronische, lumineszierende oder photovoltaische Bauelemente herzustellen, wobei diese Ausgangsstoffe durch Transport mittels eines Trägergases einer Depositionskammer zugeleitet werden, wo sie auf einem oder mehreren Substraten, die auf einem Suszeptor angeordnet sind, schichtbildend kondensieren. Als Substrate werden in der Regel Glasscheiben verwendet. Der Suszeptor wird gekühlt, so dass ein Transport der Ausgangsstoffe gegen einen negativen Temperaturgradienten erfolgt.

Ein gattungsgemäßes Verfahren wird von der DE 10338406 A1 beschrieben. Zur Herstellung von dotierten organischen Halbleitermaterialien mit erhöhter Ladungsträgerdichte und effektiver Ladungsträgerbeweglichkeit wird eine Matrix mit einem Dotanden dotiert. In einem ersten Schritt wird der Dotand sublimiert. Die dabei entstehende Leukobase ist eine Vorläufersubstanz, aus welcher in einem zweiten Schritt der Donor gewonnen wird. Die reine Leukobase wird in ein organisches Halbleitermaterial eingemischt. In derm zweiten Schritt wird die Leukobase zum Kation oxidiert. Dies erfolgt durch UV-Bestrahlung des abgeschiedenen Halbleitermaterials.

Die DE 10212923 A1 beschreibt ein Verfahren zum Beschichten eines Substrates, bei dem Vorläufersubstanzen in einem Vorratsbehälter bevorratet werden und als Gas oder Aerosol mittels eines Trägergases in eine Prozesskammer gebracht werden. Dort kondensieren sie auf einem Substrat.

Die DE 10307125 A1 beschreibt ein dotiertes organisches Halbleitermaterial, bei dem die gewünschte Dotierwirkung nach Abspaltung mindestens einer organischen molekularen Gruppe aus der chemischen Verbindung entstehen soll. Die Umwandlung findet innerhalb des abgeschiedenen Festkörpermaterials statt.

Ein sogenannter OVPD-Prozess wird in der US 5,554,220 und in der Veröffentlichung S. R. Forrest et al., "Intense Second Harmonie Generation and Long-Range Structural Ordering in Thin Films of an Organic Salt Grown by Organic Vapor Phase Deposition", 68 Appl. Phys. Lett. 1326(1996) beschrieben. Des Weiteren wird der Prozess in P. E. Burrows et. al., "Organic Vapor Phase Deposition: a New Method for the Growth of Organic Thin Films with Large Optical Non-linearities", 156 Crystal Growth 91 (1995) beschrieben. Beide Literaturstellen sowie der Inhalt der US 5,554,220 werden vollinhaltlich mit in den Offenbarungsgehalt dieser Patentanmeldung einbezogen.

Darüber hinaus werden sogenannte OLEDs (organic light emitting devices) auch in einem thermischen Vakuumverfahren VTE (vacuum thermal evaporation) gefertigt.

Die in der Regel flüssigen oder festen Ausgangsstoffe werden beim OVPD-Prozess in sogenannten Quellen bspw. durch Verdampfen in eine Gasform umgewandelt und dann vorzugsweise unter Verwendung eines Trägergases durch Gasleitungen in eine Depositionskammer transportiert. Dort befindet sich ein Gaseinlassorgan zum verteilten und dosierten Gaseinlass in eine Depositionskammer, in welcher das oben genannte Substrat liegt. Die aus diesen Schichten gefertigten Leuchtdioden (OLEDs) erzeugen bei Stromdurchfluss Licht. Der Stromdurchfluss erfolgt durch Elektronenleitung oder durch Löcherleitung, wobei die Stromdichte nicht nur von der Löcherkonzentration oder der Elektronenkonzentration, sondern auch von deren Beweglichkeit abhängt. Derzeit ist es möglich, OLEDs herzustellen mit einer Effizienz von 20 lm/W. Zur Steigerung der Effizienz ist es erforderlich, die Leitfähigkeit zu erhöhen. Hierzu werden die abgeschiedenen Schichten elektrisch dotiert. Im Stand der Technik ist es ferner bekannt, stacked OLEDs zu fertigen, indem unterschiedliche oder gleiche OLED-Stapel mit dotierten Zwischenschichten aufeinander abgeschieden werden. Neben Leuchtdioden werden auch Solarzellen mit dem beschriebenen Verfahren gefertigt. Diese photovoltaischen Bauelemente benötigen ebenfalls eine hohe Leitfähigkeit.

Neben der elektrischen Dotierung kann auch eine optische Dotierung der Schichten vorgenommen werden.

Das Abscheiden der Schicht und somit auch die Dotierung und insbesondere der Dotierstoffeinbau in die Schicht muss bei Temperaturen deutlich unter 200° C stattfinden, da die verwendeten Ausgangsstoffe sehr temperaturinstabil sind. Eine Prozessvoraussetzung ist daher das Vorhandensein einfach zu handhabender Ausgangsstoffe und insbesondere eines einfach zu handhabenden Dotierstoffs, der sich auch bei Temperaturen unter 200°C und insbesondere Raumtemperatur in die Schichtmatrix einbauen lässt und eine Dotierung bewirkt. Probleme, die mit einem Dotierstoffeinbau einhergehen, dessen Konzentration mindestens zwei Größenordnungen geringer ist als die Matrixkonzentration, werden in "Novel dopants for n-type doping of electron transport materials: cationic dyes and their bases", Dissertation, Dipl.-Chem. Fenghong Li, Januar 2005, TU Dresden, und Yasunori Kijima, Nobutoshi Asai and Shin-ichiro Tamura, "A Blue Organic Light Emitting Diode", Jpn. J. Appl. Phys. Vol.38(1999) 5274-5277, Part 1, No. 9A, 1999, beschrieben.

Anders als bei anorganischen Halbleitern, bei denen man durch gezielte Dotierung Zustände in der Bandlücke einbringen kann, müssen bei organischen Schichten die Ladungsträger auf einem organischen Molekül lokalisiert sein. Wird zusätzlich zu das Matrixmaterial bildenden Ausgangsstoffen ein Dotierstoff verwendet, so ist eine chemische Reaktion (REDOX) zwischen Dotierstoff und Matrixmaterial erforderlich. Diese chemische Reaktion verändert das organische Molekül selbst, so dass dort neue Zustände / Bindungsverhältnisse entstehen. Letzteres muss wegen der Instabilität der verwendete Moleküle bei unter 200°C und insbesondere bei Raumtemperatur stattfinden.

Aus der DE 10338406 A1 ist ein Verfahren bekannt, mit dem organische Halbleitermaterialien mit erhöhter Ladungsträgerdichte dotiert werden sollen. Die Dotierung erfolgt durch Einmischen einer neutralen organischen Verbindung in die Matrix. Die organische Verbindung liegt dabei einer hydrierten Form vor. Sie wird direkt in das organische Halbleitermaterial eingemischt. Es sind nichtionische Moleküle. Sie zeigen deshalb eine im Wesentlichen vollständige Sublimation. Die ungeladene organische Verbindung wird durch Abspaltung von Wasserstoff in ein Kation oder ein Radikal umgewandelt. Somit kann durch Übertragung eines Elektrons vom Radikal auf das Halbleitermaterial eine n-Dotierung bzw. durch Aufnahme eines Elektrons durch das Kation aus dem Halbleitermaterial eine p-Dotierung erfolgen.

Die DD 279032 A1 beschreibt ein Verfahren zur Herstellung organischer Halbleiterschichten. In einer Vakuumapparatur werden dünne Schichten auf Substraten abgeschieden. Dazu ein wird ein fester stöchiometrischer 1:1-Komplex eines Donators mit einem Acceptor und ein fester Acceptor in einem vorbestimmten, nicht ganzzahligen Verhältnis gemischt. Die verdampften Materialien scheiden sich auf dem Substrat als Schicht ab.

Die US 7,201,942 B2 beschreibt eine Vorrichtung und ein Verfahren zur Durchführung konventioneller OVPD. Oberhalb einer Prozesskammer sind mehrere Flüssigkeitsquellen angeordnet, die Ausgangsstoffe beinhalten, die im Gasphasentransport in die Prozesskammer eingeleitet werden.

Die US 6,207,238 B1 beschreibt die Abscheidung einer polymeren Schicht, wobei die Polymere in einem Hochvakuumverfahren mittels eines Plasmas vorbehandelt werden.

Der Erfindung liegt die Aufgabe zugrunde, Maßnahmen anzugeben, mit denen die Dotierung von elektronischen, lumineszierenden oder photovoltaischen Schichten verbessert wird.

Gelöst wird die Aufgabe durch die in den nebengeordneten Ansprüchen 1, 10 und 13 angegebene Erfindung, wobei die übrigen Ansprüche vorteilhafte Weiterbildungen der Verfahren bzw. der Vorrichtung sind. Gleichwohl bilden sämtliche fakultativ nebengeordneten Ansprüche aber auch eigenständige Lösung der Aufgabe.

Zunächst und im Wesentlichen wird das Verfahren dahingehend weitergebildet, dass der Dotierstoff oder die Dotierung durch Modifikation eines Ausgangsstoffes auf seiner Transportstrecke gebildet werden. Anders als bei der DE 10338406 A1 erfolgt die Modifikation nicht in der bereits abgeschiedenen Schicht, sondern entfernt vom Substrat in der Gasphase. Die Modifikation erfolgt räumlich zwischen der Quelle und dem Substrat in einer Gasphase, also nach dem Verdampfen in der Gasphase. Ein neutraler Ausgangsstoff, der ohne Modifikation zu keiner Dotierung führen würde, wird zeitlich während des Gasphasentransportes, also im gasförmigen Zustand des Ausgangsstoffes und in Anwesenheit eines Trägergases modifiziert.

Dabei findet die Modifikation des Ausgangsstoffs in einer stromabwärts der Quelle und stromaufwärts der Depositionskammer angeordneten Modifikationskammer statt. Die Modifikation ist eine Veränderung des Ausgangsstoffes. Der Ausgangsstoff kann chemisch oder physikalisch verändert werden. Bei der Modifikation kann es sich um eine Stoffumwandlung handeln. Beispielsweise kann der Ausgangsstoff in mehrere Produkte zerlegt werden. Die Modifikation kann sowohl eine Analyse als auch eine Synthese sein. Letztere wird beispielsweise dadurch verwirklicht, dass der Ausgangsstoff mit einem Reaktionspartner reagiert. Der Ausgangsstoff kann mit einem Reaktionspartner chemisch reagieren. Die Dotierung kann erreicht werden, indem ein Ausgangsstoff in geeigneter Weise chemisch umgewandelt wird, so dass die Schicht, die unter Verwendung dieses Ausgangsstoffes gebildet ist, eine höhere elektrische Leitfähigkeit oder eine andere optische Eigenschaft bekommt. Es ist aber auch möglich, dass in der Modifikationskammer lediglich eine katalytische Reaktion stattfindet. Diese kann auch durch Energiezufuhr eingeleitet werden. Alternativ oder in Kombination mit der zuvor genannten Stoffveränderung kann die Modifikation aber auch durch ledigliche Energiezufuhr verursacht werden. Die Energie kann im Wege eines Plasmas dem Ausgangsstoff zugeführt werden. Es ist aber auch möglich, die Energie mittels eines Hochfrequenzgenerators dem Ausgangsstoff zuzufügen. Auch die Verwendung von Wärme und einer die Wärme erzeugenden Heizung kommt in Betracht. Bei dieser Variante wird die Dotierung der Schicht dadurch verursacht, dass ebenfalls ein Ausgangsstoff modifiziert wird, so dass sich die Elektronendichte bzw. die Löcherdichte in der abgeschiedenen Schicht erhöht bzw. sich die optischen Eigenschaften der abgeschiedenen Schicht ändern. Es kann sich hier lediglich um eine energetische Anregung handeln. In einer Variante der Erfindung ist vorgesehen, dass ein den Dotierstoff bildender Ausgangsstoff, also eine Vorstufe des Dotierstoffes modifiziert wird. Die Vorstufe des Dotierstoffes kann selbst nicht in der Lage sein, unter Erhöhung der Leitfähigkeit in die Matrix eingebaut zu werden. Die Vorstufe des Ausgangsstoffes muss dann vielmehr zunächst in der zuvor erwähnten Weise modifiziert werden, um einen Dotierstoff zu erzeugen, der in die Matrix eingebaut werden kann. Dabei erfolgt die Mischung des durch Modifikation eines Ausgangsstoffes erzeugten Dotierstoffs mit ein oder mehreren die Matrix bildenden anderen Ausgangsstoffen in der Modifikationskammer oder in einer Mischkammer, die stromabwärts der Modifikationskammer angeordnet ist. In der Variante, bei der der Dotierstoff durch Modifikation eines Ausgangsstoffes erzeugt wird, würde der Ausgangsstoff ohne Modifikation in der Schicht eine nicht oder schlecht leitende Schicht ausbilden. Er bekommt durch die Modifizierung eine Dotierstoffeigenschaft. Wird dieser modifizierte Ausgangsstoff in die Matrix eingebaut, so wird die elektrische Leitfähigkeit erhöht. Auch hier kann die Modifikation durch Energiezufuhr, durch Synthese oder Analyse erfolgen. Bei der Modifikation können Ionen oder neutrale Radikale gebildet werden. Diese Ionen bzw. neutralen Radikale können die Dotierstofffunktion entfalten. Sie werden über einen Gasstrom bei einem Totaldruck von mehr als 0,1 mbar, insbesondere mehr als 1 mbar in die Prozesskammer geleitet. Die kinetische Energie der bei der Modifikation erzeugten Ionen kann durch elektrische Filter beeinflusst werden. Die elektrischen Filter sind vorzugsweise einer Modifikationskammer zugeordnet. Als matrixbildende Ausgangsstoffe kommen alq₃, α-NPD, CuPC oder C₆₀ in Betracht. Als Vorstufe des Dotierstoffes kann insbesondere C₆₀ verwendet werden. Zur Modifikation eines Ausgangsstoffes kann zur Erzeugung eines n-leitenden Dotierstoffs CO, H₂ in Verbindung mit einem Plasma, TMGa, CH₄ in Verbindung mit einem Plasma oder NH₃ verwendet werdet werden. Zur Erzeugung eines p-leitenden Dotierstoffs kann O₃, N₂O zusammen mit einem Plasma, O₂ zusammen mit einem Plasma, NOₓ, SF₆ zusammen mit einem Plasma, CF₄ zusammen mit einem Plasma oder irgendein Halogen (F₂, Cl₂, Br₂, I₂ ...) verwendet werden. Es ist von Vorteil, wenn zur Modifikation die Bewegungsenergie erzeugter Ionen durch elektrostatische Felder beeinflusst wird. Elektrostatische Felder können eine entsprechend hohe Feldstärke aufweisen. Mit elektrischen Feldern kann auch ein Plasma zur Modifikation erzeugt werden. Dies erfolgt mit einem Gleichspannungsplasmagenerator oder mit einem Wechselspannungsplasmagenerator. Es ist auch vorgesehen, dass eine chemische Reaktion eines der Ausgangsstoffe mit einem Reaktionspartner vor dem Eintritt in die Depositionskammer erfolgt. Eine Vorstufe des Dotierstoffs kann in einer stromaufwärts der Depositionskammer angeordneten Modifikationskammer in einen Dotierstoff umgewandelt werden.

Der Dotierstoffeinbau kann ein- und ausgeschaltet werden, wobei bei einer Plasma-Anwendung der Dotierstoff gebildet wird oder bei Plasma-Anwendung ein Vorprodukt des Dotierstoffs. Als Trägergas können die bekannten Trägergase wie Wasserstoff, Stickstoff oder ein geeignetes Edelgas / Inertgas verwendet werden. Das Verfahren kann bei einem Totaldruck von 1 mbar durchgeführt werden. Das Verfahren kann in einer Vorrichtung durchgeführt werden, bei der es sich um einen bekannten OVPD-Reaktor handelt, der ein oder mehrere Quellen aufweist sowie Gasleitungen zwischen Quellen und einer Depositionskammer. Dieser OVPD-Reaktor wird erfindungsgemäß dadurch weitergebildet, dass stromabwärts der ein oder mehreren Quellen und stromaufwärts der Depositionskammer ein oder mehrere Modifikationskammern vorgesehen sind. In dieser Modifikationskammer kann ein Ausgangsstoff durch Energiezufuhr und / oder durch Reaktionsgaszufuhr modifiziert werden. Die Modifikationskammer kann einen Plasma-Generator umfassen, in dem ein Gleichspannungsplasma oder ein Wechselspannungsplasma erzeugt werden. Darüber hinaus kann die Modifikationskammer einen Hochfrequenzgenerator umfassen, um ein RF-Feld aufzubauen, mit dem der Ausgangsstoff modifiziert werden kann. Die Modifikationskammer kann auch einen Gaseinlass zum Einlass eines Reaktionsgases oder eine Heizung umfassen. Zwischen der ein oder mehreren Modifikationskammer und der Depositionskammer kann sich eine Mischkammer befinden, in welche Gasleitungen mehrerer Quellen münden. Beispielsweise kann in einer Quelle als Ausgangsstoff eine Vorstufe des Dotierstoffs bereitgestellt werden. Dieser Ausgangsstoff wird über einen Trägergasstrom in die Modifikationskammer geleitet. In dieser Modifikationskammer wird die Vorstufe des Dotierstoffes modifiziert zu einem Dotierstoff, der dann mit dem Gasstrom in die Mischkammer geleitet wird. In mindestens einer anderen Quelle kann bei dieser Variante ein eine Matrix bildender Ausgangsstoff bereitgestellt werden. Dieser kann direkt oder ebenfalls durch eine Modifikationskammer strömend der Mischkammer zugeleitet werden. Dotierstoff und matrixbildender Ausgangsstoff werden in der Mischkammer homogenisiert. Dort kann bereits eine Gasphasenreaktion stattfinden. Die Konzentrationsverhältnisse sind so gewählt, dass der Dotierstoff in etwa hundertmal geringerer Konzentration in der Gasphase vorkommt als der matrixbildende Ausgangsstoff. Das Gasgemisch wird in die Depositionskammer geleitet und kondensiert auf dem Substrat, welches sich auf einem gekühlten Suszeptor befinden kann. Die Bereitstellung der Ausgangsstoffe erfolgt in der im Stand der Technik beschriebenen Weise, nämlich insbesondere durch Bildung von Aerosolen oder durch Verdampfen eines Festkörpers oder einer Flüssigkeit. In einer Weiterbildung der Erfindung wird ein Reaktionsgas als Ausgangsstoff in die Modifikationskammer geleitet. Der Modifikationskammer kann eine Plasmazelle vorgeordnet sein, in der das Reaktionsgas mit einem Plasma behandelt werden kann. Das Plasma kann zur Aktivierung des Reaktionsgases dienen.

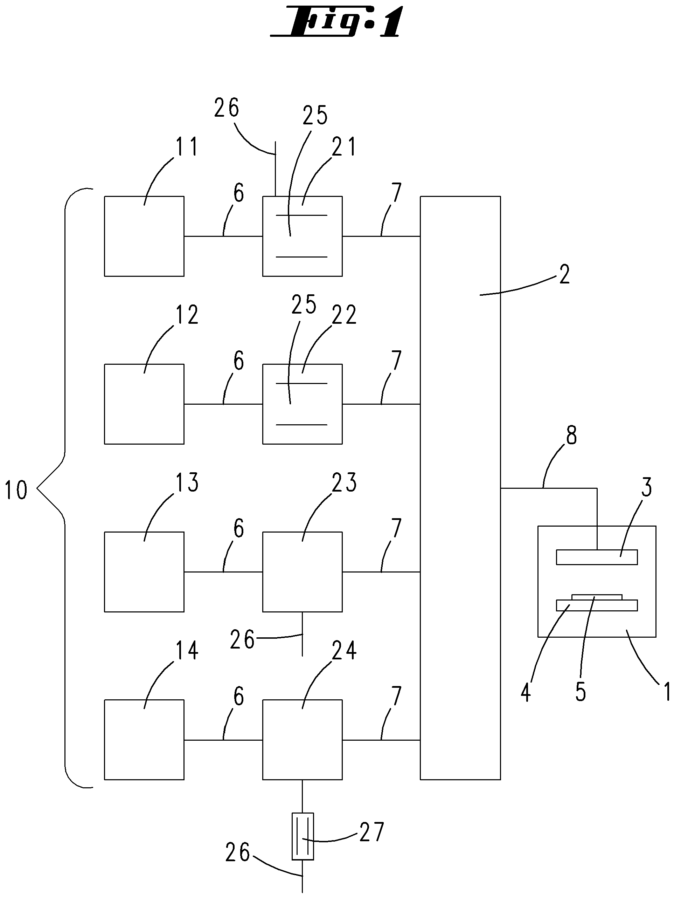

Die Fig. 1 zeigt ein Ausführungsbeispiel der Erfindung. Mit der Bezugsziffer 10 ist eine Quellenanordnung bezeichnet, die aus im Ausführungsbeispiel insgesamt vier Quellen 11, 12, 13, 14 besteht. Erfindungsgemäß braucht aber lediglich eine einzige Quelle 11 vorhanden sein. Diese einzige oder die im Ausführungsbeispiel vier Quellen 11, 12, 13, 14 sind jeweils mit Gasleitungen 6 mit einer der jeweiligen Quelle 11, 12, 13, 14 individuell zugeordneten Modifikationskammer 21, 22, 23, 24 verbunden. Jede der Modifikationskammern 21, 22, 23, 24 ist mit einer Mischkammer 2 verbunden. Dies erfolgt über die mit der Bezugsziffer 7 bezeichnete Gasleitung. Alternativ dazu können auch ein oder mehrere Quellen 11, 12, 13, 14 direkt ohne Zwischenschaltung einer Modifikationskammer mit der Mischkammer 2 verbunden sein.

Stromabwärts der Mischkammer befindet sich eine mit der Gasleitung 8 mit der Mischkammer 2 verbundene Depositionskammer 1. Diese weist ein Gaseinlasssystem 3 auf, welches von der Gasleitung 8 gespeist wird. Unterhalb des Gaseinlassorgans 3 befindet sich eine Depositionskammer, deren Boden von einem wassergekühlten Suszeptor 4 gebildet wird. Auf dem Suszeptor 4 liegt ein Substrat 5, beispielsweise in Form einer Glasscheibe, welche mit einer elektronischen, lichtemittierenden oder photovoltaischen Schicht aus organischen Molekülen beschichtet werden soll. Der Totaldruck in der Prozesskammer ist größer als 0,1 mbar und bevorzugt größer als 1 mbar. Er kann auch größer als 10 mbar sein, so dass die Anwesenheit des Trägergases eine kinetische Wirkung entfalten kann.

Die organischen Moleküle bilden feste, flüssige oder gasförmige Ausgangsstoffe, die in den Quellen 11, 12, 13, 14 bevorratet werden. Sie werden dort entweder durch Verdampfen in die Gasphase überführt oder mittels Injektionsdüsen in Aerosole umgewandelt, die über einen Trägergasstrom transportiert werden können.

Eine der Quellen 11, 12, 13, 14 enthält ein die Schicht bildendes, zuvor als matrixbildenden Ausgangsstoff bezeichnetes Material.

Es ist auch möglich, dass eine der Quellen 11,12,13,14 einen Ausgangsstoff enthält, der eine Vorstufe eines Dotierstoffs ist.

Die Modifikationskammern 21, 22, 23, 24 enthalten Einrichtungen, mit denen der durch diese Modifikationskammer 21, 22, 23, 24 strömende Ausgangsstoff modifiziert werden kann. Die Modifikation kann dabei eine ledigliche physikalische Anregung sein. Sie kann aber auch eine chemische Reaktion, bspw. eine Analyse oder eine Synthese sein. Handelt es sich bei der chemischen Reaktion um eine Synthese, so kann durch eine Reaktionsgaszuleitung 26 ein weiteres Reaktionsgas in die Modifikationskammer 21, 24 eingeleitet werden, wobei hier auch eine Plasmazelle 27 vorsehen sein kann, mit der das Reaktionsgas, welches durch die Reaktionsgaszuleitung 26 strömt, vor dem Eintritt in die Modifikationskammer angeregt wird.

Die Modifikation innerhalb der Modifikationskammer 21, 22 kann über ein Plasma erfolgen. Hierzu ist in der Modifikationskammer 21, 22 ein Plasmagenerator 25 vorgesehen, der ein Gleichspannungsplasma oder ein Wechselspannungsplasma erzeugt. Mit diesem Plasma können physikalische Anregungen oder chemische Umformungen / Zerstörungen der Moleküle vorgenommen werden. Es ist ebenfalls möglich, innerhalb einer Modifikationskammer 23 ein RF-Feld zu erzeugen, um die Ausgangsstoffe anzuregen oder chemisch umzuwandeln. Schließlich ist als Energiezufuhr für die Modifikation auch eine Heizung vorgesehen.

Als Reaktionsgas kann durch die Reaktionsgasleitung 26 CO, H₂, TMGa, CH₄ oder NH₃ geleitet werden. H₂ und CH₄ werden in der Modifikationskammer 21 über den Plasma-Generator 25 zerlegt. Eine derartige Zerlegung kann aber auch vor der Modifikationskammer 24 mit der Plasmazelle 27 durchgeführt werden. Bei der Zerlegung entstehen Ionen oder Radikale, bspw. elementarer Wasserstoff, elementarer Stickstoff oder dergleichen. Diese Radikale können n-dotierend in die Matrix eingebaut werden. Es handelt sich dabei um reduzierende Gase.

Alternativ können auch oxidierende Gase wie O₃, N₂O, O₂, NOₓ, SF₆, CF₄ oder Halogene wie F₂, Cl₂, Br₂ oder I₂ verwendet werden. Auch hier können die Reaktionsgase mit einem Plasma in Radikale oder in Ionen zerlegt werden. Ist das Zerlegungsprodukt ein Ion, so können die Modifikationskammern 21, 22, 24 auch elektrostatische Filter besitzen, um die kinetische Energie dieser Ionen zu beeinflussen.

Als Ausgangsstoffe für eine p-Dotierung oder eine n-Dotierung kommen auch alle anderen, als Dotierstoffe oder Vorstufen von Dotierstoffen bekannten chemischen Verbindungen in Betracht.

In Betracht kommen schließlich auch die matrixbildenden Ausgangsstoffe wie alq₃ oder α-NPD. Letztere werden mit der Modifikation derart umgewandelt, dass sie andere elektronische oder optische Eigenschaften bekommen.

Mit der in Fig. 1 dargestellten Vorrichtung ist es aber auch möglich, die Modifikationskammern 21, 22, 23, 24 als "Cracker-Zellen" zu verwenden. Mit einem entsprechend leistungsstarken Plasma können die matrixbildenden Ausgangsstoffe zerstört werden. Die Zerlegungsprodukte sind dann nicht in der Lage, schichtbildend auf dem Substrat zu kondensieren. Sie durchströmen die Depositionskammer 1, ohne dort zu deponieren. Erst wenn das Plasma wieder abgeschaltet wird, können diese Ausgangsstoffe die "Cracker-Zellen" unbeeinflusst passieren, um dann in der Depositionskammer 1 schichtbildend auf dem Substrat 5 zu kondensieren. Mit der in der Fig. 1 dargestellten Vorrichtung ist somit die Verwirklichung eines virtuellen Run-Vent-Systems möglich.

## Patentansprüche

1. Verfahren zum Herstellen dotierter Schichten für elektronische, lumineszierende oder photovoltaische Bauelemente, wobei ein oder mehrere flüssige oder feste Ausgangsstoffe in einer Quelle (11, 12, 13, 14) verdampfen oder als Aerosol einem Trägergas beigemischt werden und in dieser Form in eine Depositionskammer (1) transportiert werden, wo sie insbesondere in Folge eines Temperaturgradienten eine dotierte Matrix bildend auf einem Substrat (5) kondensieren, wobei die Dotierung durch Modifikation eines Ausgangsstoffes, der ohne Modifikation keine dotierende Wirkung entfaltet, erfolgt, **dadurch gekennzeichnet, dass** die Modifikation des Ausgangsstoffes oder einer Vorstufe desselben in einer stromabwärts der Quelle (11, 12, 13, 14) und stromaufwärts der Depositionskammer (1) angeordneten Modifikationskammer (21, 22, 23, 24) in Anwesenheit des Trägergases stattfindet.

2. Verfahren nach Anspruch 1, **dadurch gekennzeichnet, dass** die Modifikation eine Molekülveränderung ist, die durch Energiezufuhr und / oder durch einen oder mehrere physikalische oder chemische Reaktionspartner verursacht wird, wobei die Energie, insbesondere im Wege eines Plasmas, einer RF-Anregung oder durch Wärme zugeführt wird.

3. Verfahren nach einem der vorhergehenden Ansprüche, **dadurch gekennzeichnet, dass** die Modifikation vor der Mischung mit einem oder mehreren die Matrix bildenden Ausgangsstoffen erfolgt.

4. Verfahren nach einem der Ansprüche 1 bis 3, **dadurch gekennzeichnet, dass** die Dotierung durch Modifikation eines die Matrix bildenden Ausgangsstoffs erzeugt wird.

5. Verfahren nach einem der vorhergehenden Ansprüche, **dadurch gekennzeichnet, dass** der durch die Modifikation gebildete Dotierstoff neutrale Radikale aufweist.

6. Verfahren nach einem der vorhergehenden Ansprüche, **dadurch gekennzeichnet, dass** als matrixbildender Ausgangsstoff alq₃, α-NPD, CuPC und/oder C₆₀ verwendet wird.

7. Verfahren nach einem der vorhergehenden Ansprüche, **dadurch gekennzeichnet, dass** zur Modifikation eines Ausgangsstoffes O₃, N₂O, O₂, NOₓ, SF₆, CF₄ und / oder ein Halogen verwendet wird und insbesondere eine chemische Reaktion stattfindet.

8. Vorrichtung zum Abscheiden dotierter Schichten für elektronische, lumineszierende oder photovoltaische Bauelemente, mit ein oder mehreren Quellen (11, 12, 13, 14), in welchen ein oder mehrere flüssige oder feste Ausgangsstoffe verdampft oder als Aerosol einem Trägergas beigemischt werden und mit dem Trägergas durch eine Gasleitung (6, 7, 8) in eine Depositionskammer transportiert werden, wo sie auf einem von einem Suszeptor (4) getragenen Substrat (5) als Schicht abgeschieden werden, **gekennzeichnet durch** eine stromabwärts der ein oder mehreren Quellen (11, 12, 13, 14) und stromaufwärts der Depositionskammer (1) angeordneten Modifikationskammer (21, 22, 23, 24), in welcher zumindest ein ohne Modifikation keine dotierende Wirkung entfaltender Ausgangsstoff durch Energiezufuhr und/oder Reaktionsgaszufuhr derart modifiziert wird, dass er eingebaut in der Schicht als Dotierstoff wirkt.

9. Vorrichtung nach Anspruch 8, **gekennzeichnet durch** eine stromabwärts der Modifikationskammer (21, 22, 23, 24) angeordnete Mischkammer (2), in welche Gasleitungen (7) mehrerer Quellen (11, 12, 13, 14) münden.

10. Vorrichtung nach einem der Ansprüche 8 oder 9, **gekennzeichnet durch** eine einer Reaktionsgaszuleitung (26) in die Modifikationskammer (24) zugeordnete Plasmazelle (27) zur Modifikation des Reaktionsgases.

## Claims

1. Method for producing doped layers for electronic, luminescent or photovoltaic components, one or more liquid or solid starting materials being evaporated in a source (11, 12, 13, 14) or being admixed as an aerosol to a carrier gas and transported in this form into a deposition chamber (1), where they condense, in particular as a result of a temperature gradient, on a substrate (5) so as to form a doped matrix, the doping occurring by modifying a starting material that does not develop a doping effect without modification, **characterised in that** the starting material or a precursor thereof are modified in the presence of the carrier gas in a modification chamber (21, 22, 23, 24) that is arranged downstream of the source (11, 12, 13, 14) and upstream of the deposition chamber (1).

2. Method according to claim 1, **characterised in that** the modification is a molecular change which is caused by the supply of energy and/or by one or more physical or chemical reactants, the energy being supplied in particular by way of a plasma, by RF excitation or by heat.

3. Method according to either of the preceding claims, **characterised in that** the modification occurs before the mixing with one or more starting materials that form the matrix.

4. Method according to any of claims 1 to 3, **characterised in that** the doping is generated by modifying a starting material that forms the matrix.

5. Method according to any of the preceding claims, **characterised in that** the dopant formed by the modification comprises neutral radicals.

6. Method according to any of the preceding claims, **characterised in that** alq₃, α-NPD, CuPC and/or C₆₀ is used as the matrix-forming starting material.

7. Method according to any of the preceding claims, **characterised in that** O₃, N₂O, O₂, NOₓ, SF₆, CF₄ and/or a halogen is used for the modification of a starting material and in particular a chemical reaction occurs.

8. Device for depositing doped layers for electronic, luminescent or photovoltaic components, comprising one or more sources (11, 12, 13, 14) in which one or more liquid or solid starting materials are evaporated or admixed as an aerosol to a carrier gas and transported together with the carrier gas via a gas line (6, 7, 8) into a deposition chamber, where they are deposited as a layer on a substrate (5) carried by a susceptor (4), **characterised by** a modification chamber (21, 22, 23, 24) arranged downstream of the one or more sources (11, 12, 13, 14) and upstream of the deposition chamber (1), in which modification chamber at least one starting material that does not develop a doping effect without modification is modified by the supply of energy and/or supply of reactive gas such that it acts as a dopant incorporated in the layer.

9. Device according to claim 8, **characterised by** a mixing chamber (2) arranged downstream of the modification chamber (21, 22, 23, 24), into which mixing chamber gas lines (7) from a plurality of sources (11, 12, 13, 14) lead.

10. Device according to either claim 8 or claim 9, **characterised by** a plasma cell (27) associated with a reactive gas supply line (26) into the modification chamber (24) for the modification of the reactive gas.

## Revendications

1. Procédé de production de couches dopées destinées à des composants électroniques, luminescents ou photovoltaïques, au moins une matière de départ liquide ou solide s'évaporant dans une source (11, 12, 13, 14) et se mélangeant sous forme d'aérosol à un gaz porteur et étant transportée sous cette forme jusque dans une chambre de dépôt (1) où elle se condensent notamment sous l'effet d'un gradient de température sur un substrat (5) en formant une matrice dopée, le dopage se produisant par modification d'une matière de départ qui ne développe aucun effet dopant sans modification, **caractérisé en ce que** la modification de la matière de départ ou de son précurseur se produit en présence du gaz porteur dans une chambre de modification (21, 22, 23, 24) placée en aval de la source (11, 12, 13, 14) et en amont de la chambre de dépôt (1).

2. Procédé selon la revendication 1, **caractérisé en ce que** la modification est un changement moléculaire provoqué par un apport d'énergie et/ou par au moins un réactifs physiques ou chimiques, l'énergie étant apportée notamment par le biais d'un plasma, d'une excitation RF ou par de la chaleur.

3. Procédé selon l'une des revendications précédentes, **caractérisé en ce que** la modification se produit avant le mélange à au moins une matière de départ formant la matrice.

4. Procédé selon l'une des revendications 1 à 3, **caractérisé en ce que** le dopage est généré par modification d'une matière de départ formant la matrice.

5. Procédé selon l'une quelconque des revendications précédentes, **caractérisé en ce que** le dopant formé par la modification comporte des radicaux neutres.

6. Procédé selon l'une quelconque des revendications précédentes, **caractérisé en ce que** l'on utilise comme matière de départ formant la matrice alq₃, α-NPD, CuPC et/ou C₆₀.

7. Procédé selon l'une des revendications précédentes, **caractérisé en ce que** l'on utilise O₃, N₂O, O₂, NOₓ, SF₆, CF₄ et/ou un halogène et on produit en particulier une réaction chimique pour modifier une matière de départ.

8. Dispositif de dépôt de couches dopées destinées à des composants électroniques, luminescents ou photovoltaïques, comprenant au moins une source (11, 12, 13, 14) dans laquelle au moins une matière de départ liquides ou solides est vaporisée ou mélangées sous forme d'aérosol à un gaz porteur, et est transportée avec le gaz porteur à travers un conduit de gaz (6, 7, 8) jusque dans une chambre de dépôt où elle est déposée en couche sur un substrat (5) porté par un suscepteur (4), **caractérisé par** une chambre de modification (21, 22, 23, 24) qui est disposée en aval de l'au moins une source (11, 12, 13, 14) et en amont de la chambre de dépôt (1) et dans laquelle au moins une matière de départ, qui ne développe aucun effet dopant sans modification, est modifiée par apport d'énergie et/ou apport de gaz de réaction de manière à agir comme dopant en étant incorporée dans la couche.

9. Dispositif selon la revendication 8, **caractérisé par** une chambre de mélange (2) qui est disposée un aval de la chambre de modification (21, 22, 23, 24) et dans laquelle débouchent des conduits de gaz (7) de plusieurs sources (11, 12, 13, 14) .

10. Dispositif selon l'une des revendications 8 ou 9, **caractérisé par** une cellule à plasma (27), destinée à modifier le gaz de réaction, qui est associée à un conduit d'apport de gaz de réaction (26) débouchant dans la chambre de modification (24).
